# EUROPEAN PATENT APPLICATION

(11) **EP 1 202 406 A2**
(43) Date of publication of application: **02.05.2002**
(21) Application number: 01115162.8
(22) Date of filing: 22.06.2001
(51) Int. Cl.: H01S 5/068, G02B 6/42

(54) **Laser diode module with stable optical output**

(30) Priority: 24.10.2000 JP 2000324033
(71) Applicant: MITSUBISHI DENKI KABUSHIKI KAISHA, Tokyo 100-8310 (JP)
(72) Inventor: Koyanagi, Haruki, Chiyoda-ku, Tokyo 100-8310 (JP)
(74) Representative: Pfenning, Meinig & Partner GbR

(57) **Abstract**

An optical isolator is secured so that a direction of polarization permitted to pass through the optical isolator is angled against a direction of polarization of a laser beam entering the optical isolator so that the laser beam transmitted by the optical isolator is attenuated and an optical output from an optical fiber, located at a maximum coupling point, is at a desired level.

## Description

### BACKGROUND OF THE INVENTION

### 1. Field of the Invention

The present invention generally relates to a laser diode module and, more particularly, to an improvement in a laser diode module used in an optical fiber communication for stable optical output.

### 2. Description of the Related Art

For transmission of an optical signal in an optical communication system, a transmitter for transmitting an optical signal and a receiver for receiving an optical signal are used. A transmitter is required to provide a predetermined level of optical output adapted for the system. The level of optical output may be determined by a distance of transmission and/or the receiving responsivity of the receiver. Each laser diode used in laser diode modules has its optimum bias current level to provide a required performance in analog or digital communication. Laser diodes driven by respective optimum bias currents provide different optical outputs. In fabricating a laser diode module, the laser diode-to-fiber coupling efficiency must be individually controlled in order to provide an optical output adapted for the system when the laser diode module is driven by the optimum bias current.

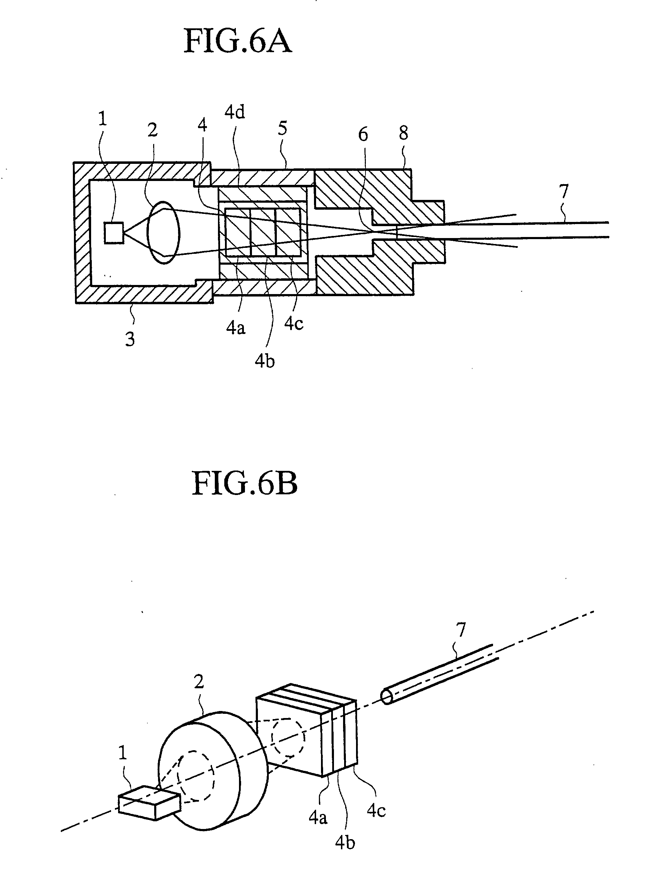

Figs. 6A and 6B show a construction of a laser diode module extensively used in the related art. Fig. 6A is a sectional view of the laser diode module and Fig. 6B is a perspective view showing an arrangement of components constructing an optical system of the laser diode module. Referring to Figs. 6A and 6B, reference numeral 1 indicates a laser diode, 2 indicate a lens provided on an optical path of a laser beam emitted by the laser diode 1, 3 indicates a case for securing the laser diode 1 and the lens 2. A polarizer 4a, a rotator 4b, an analyzer 4c and a magnet 4d constitute an optical isolator 4 provided on an optical path of the laser beam passing through the lens 2, the polarizer 4a facing the lens 2. The magnet 4d is provided around the rotator 4b so as to cause the rotator 4b to rotate by 45° the direction of polarization of the laser beam passing through by a magneto-optical effect. The polarizer 4a is placed so that the direction of polarization of the laser beam permitted to pass through the polarizer 4a matches that of the laser beam past the lens 2. Reference numeral 5 indicates an optical isolator holder holding the optical isolator 4 and secured to the case 3, 6 indicates a maximum coupling point at which occurs maximum coupling of the laser beam to an optical fiber, 7 indicates an optical fiber coupling the laser beam transmitted by the optical isolator 4 and outputting light, and 8 indicates an optical fiber holder holding the optical fiber 7 and secured to the optical isolator holder 5. The optical fiber 7 is secured to a position at a predetermined distance away from the maximum coupling point 6 to provide a desired level of optical output from the optical fiber 7.

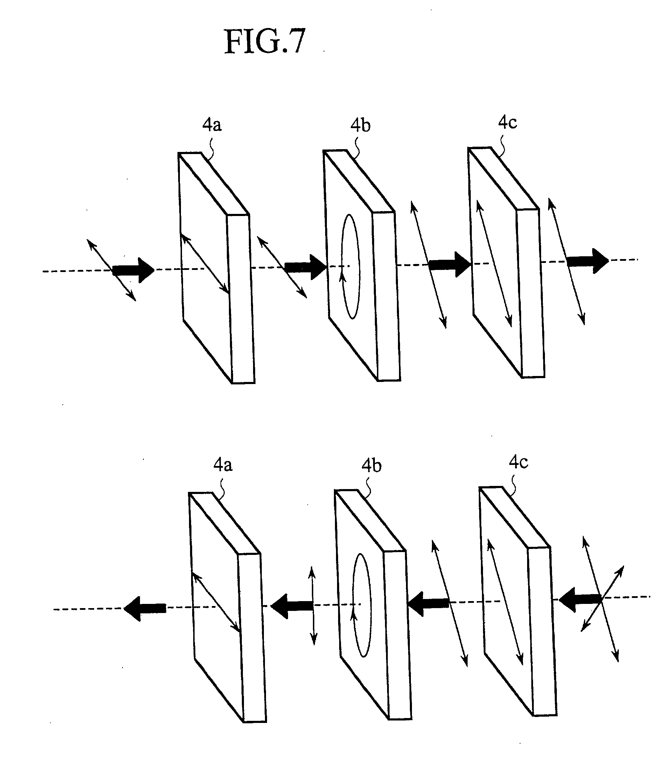

Fig. 7 shows a principle of the optical isolator of Figs. 6A and 6B. The laser beam entering the polarizer 4a in a forward direction, i.e. from left in the figure, is transmitted by the polarizer 4a such that only the component that matches the direction of polarization transmitted by the polarizer 4a is selected. The laser past the polarizer 4a has its direction of polarization rotated by 45° by the rotator 4b. The laser beam past the rotator 4b passes through the analyzer 4c capable of transmitting the direction of polarization that matches the direction of polarization of the rotated laser beam. In the laser diode module shown in Figs. 6A and 6B, the direction of polarization of the laser beam permitted to pass through the polarizer 4a matches that of the laser beam past the lens 2 so that the optical output of the laser beam passing through the analyzer 4c is maximized. The returning laser beam, i.e. the laser beam entering the analyzer 4c from right in the figure is transmitted by the analyzer 4c such that only the component that matches the direction of polarization transmitted by the analyzer 4c is selected. The polarization direction of the laser past the analyzer 4c is rotated 45° by passing through the rotator 4b in the same direction as the direction of rotation provided to the laser beam entering in the forward direction. This results in the direction of polarization of the returning laser beam being 90° apart from the direction of polarization permitted to pass through the polarizer 4a. Accordingly, the returning laser beam is not permitted to pass through the polarizer 4a.

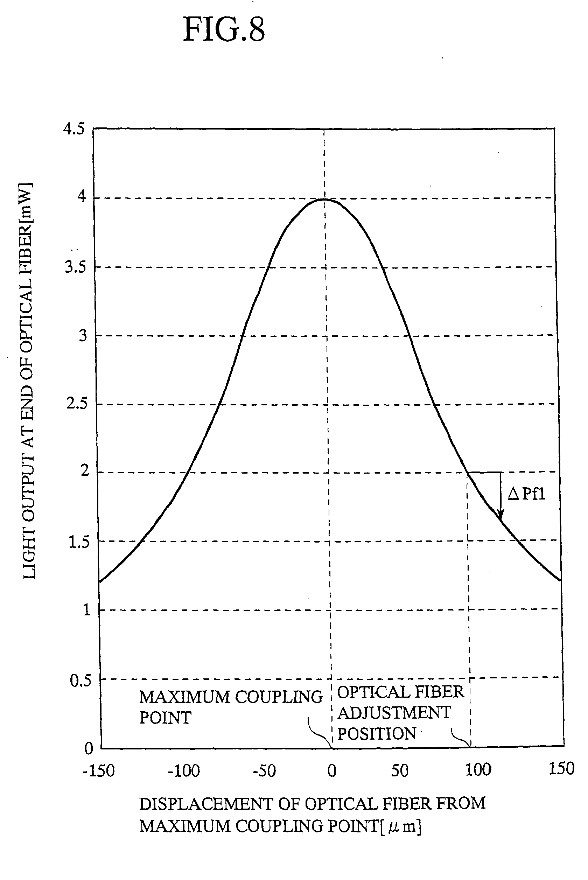

Fig. 8 is a graph showing a relationship between the position of the optical fiber 7 and the optical output provided by the optical fiber 7 occurring when an optimum bias current is supplied to the laser diode 1. The intensity of laser beam is assumed to exhibit a gaussian distribution. The spot size of the laser diode 1 is 1µm, the spot size of the optical fiber 7 is 5µm, the power of the optical system between the laser diode 1 and the optical fiber 7 is 4, and the maximum optical output of the optical fiber 7 is 4mW when the optimum bias current is supplied to the laser diode 1. The point at which the optical fiber 7 should be secured to provide a desired level of optical output is known by referring to Fig. 8. When the desired optical output is 2mW, it is necessary to secure the optical fiber 7 at a point removed by 98µm from the maximum coupling point 6.

In the related-art laser diode module, the laser beam emitted by the laser diode 1 is converged by the lens 2, transmitted by the optical isolator 4, and optically coupled to the optical fiber 7. With this, the desired level of optical output is provided by the optical fiber 7 when the optimum bias current is supplied to the laser diode 1. The laser beam returning to the laser diode 1 is blocked by the optical isolator 4 so that degradation in the performance of the laser diode 1 is prevented.

In the related-art laser diode module, the optical fiber 7 is removed from the maximum coupling point 6. As suggested in Fig. 8, this has a disadvantage in that the optical output from the optical fiber 7 is likely to incur a variation when the optical fiber 7 is slightly moved from the original position due to deformation caused by stress or variation in ambient temperature. Fabrication of a laser diode module is not easy because, when the position of the optical fiber 7 is slightly displaced from the desired location as a result of inappropriate fabrication, the resulting optical output is significantly deviated from the desired level.

### SUMMARY OF THE INVENTION

Accordingly, a general object of the present invention is to provide a laser diode module in which the aforementioned disadvantages are eliminated.

Another and more specific object is to provide a laser diode module which provides a desired level of optical output in a stable manner and which can be fabricated easily.

The aforementioned objects can be achieved by a laser diode module comprising: a laser diode; a lens provided on an optical path of a laser beam emitted by the laser diode; a polarizer provided on an optical path of the laser beam transmitted by the lens; and an optical fiber provided at a location to which the laser beam transmitted by the polarizer is optimally coupled, wherein the polarizer is angled so that a direction of polarization permitted to pass through the polarizer is angled against a direction of polarization of the laser beam transmitted by the lens.

The optical fiber may be provided in the vicinity of the location to which the laser beam transmitted by the polarizer is optimally coupled.

The polarizer may be placed so that the direction of polarization permitted to pass through the polarizer is angled against a direction of polarization of the laser beam from the laser diode at an angle that ensures a desired level of optical output from the optical fiber.

The aforementioned objects can also be achieved by a laser diode module comprising: a laser diode; a lens provided on an optical path of a laser beam emitted by the laser diode; an optical isolator provided on an optical path of the laser beam transmitted by the lens and including a polarizer, a rotator and an analyzer; and an optical fiber provided at a location to which the laser beam transmitted by the optical isolator is optimally coupled, wherein the optical isolator is placed so that a direction of polarization permitted to pass through the optical isolator is angled against a direction of polarization of the laser beam from the laser diode.

The optical fiber may be provided in the vicinity of the location to which the laser beam transmitted by the optical isolator is optimally coupled.

The optical isolator may be placed so that the direction of polarization permitted to pass through the optical isolator is angled against a direction of polarization of the laser beam from the laser diode at an angle that ensures a desired level of optical output from the optical fiber.

The aforementioned objects can also be achieved by a laser diode module comprising: a laser diode; a lens provided on an optical path of a laser beam emitted by the laser diode; an optical fiber provided with an end surface facing the lens and leaned against an axis of the optical fiber, and placed so that the laser beam transmitted by the lens is coupled into the optical fiber at an angle against the axis of the optical fiber, the end surface of the optical fiber being provided at a location at which the laser beam transmitted by the lens is coupled into the optical fiber with a maximum efficiency, and the optical fiber being leaned against the axis at an angle that ensures a desired level of optical output.

### BRIEF DESCRIPTION OF THE DRAWINGS

Other objects and further features of the present invention will be apparent from the following detailed description when read in conjunction with the accompanying drawings, in which:
Fig. 1A is a sectional view of a laser diode module according to a first embodiment;
Fig. 1B is a perspective view showing an arrangement of components constituting an optical system of the laser diode module according to the first embodiment;
Fig. 2 shows optical components and a direction of polarization of a transmitted laser beam according to the first embodiment;
Fig. 3 is a graph showing a relationship between a position of an optical fiber and an optical output provided by the optical fiber according to the first embodiment;
Fig. 4 shows a construction of a laser diode module according to a third embodiment of the present invention;
Fig. 5 shows a relationship between an angle of rotation of an optical fiber and a level of optical output from the optical fiber at a maximum coupling point, according to the third embodiment;
Fig. 6A is a sectional view of a laser diode module according to the related art;
Fig. 6B is a perspective view showing an arrangement of components constructing an optical system of the laser diode module according to the related art;
Fig. 7 shows a principle of an optical isolator; and
Fig. 8 is a graph showing a relationship between a position of an optical fiber and an optical output provided by the optical fiber, occurring in a related-art laser diode module.

### DESCRIPTION OF THE PREFERRED EMBODIMENTS

### First embodiment

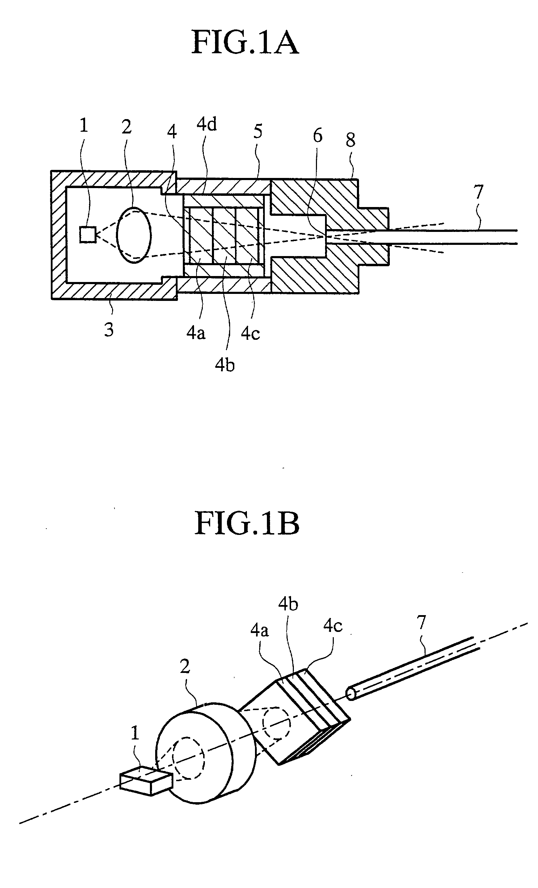

Figs. 1A and 1B show a construction of a laser diode module according to a first embodiment of the present invention. Fig. 1A is a sectional view of the laser diode module and Fig. 1B is a perspective view showing an arrangement of components constituting an optical system of the laser diode module. Referring to Figs. 1A and 1B, reference numerals 1-8 indicate components identical to the corresponding components of the related-art laser diode module so that the description thereof is omitted. The direction of polarization permitted to pass through the polarizer 4a constituting the optical isolator 4 is angled against the direction of polarization of the laser beam past the lens 2 to ensure that the optical output of the optical fiber 7, placed at the maximum coupling point 6, is at a desired level. The optical fiber 7 is secured so that the end surface of the optical fiber 7 facing the isolator 4 is located at the maximum coupling point.

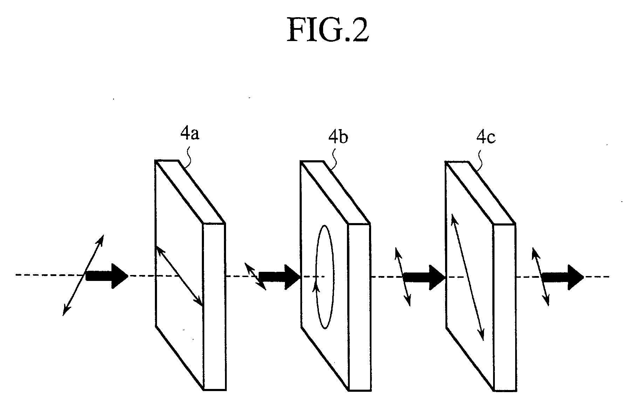

Fig. 2 shows the components constituting the optical isolator 4 and the status of polarization of the laser beam transmitted therethrough. The direction of polarization permitted to pass through the polarizer 4a of the optical isolator 4 is angled against the direction of polarization of the incident laser beam. This is equivalent to angling of the direction of polarization of the laser beam with respect to the polarizer 4a of the optical isolator 4 as the laser beam enters the optical isolator 4. Therefore, for convenience, Fig. 2 shows that the direction of polarization of the incident laser beam, instead of the optical components, is angled as the laser beam enters an optical system of the same optical component arrangement as that of Fig. 7. The laser beam entering the polarizer 4a in a forward direction, i.e. from left in the figure, is transmitted by the polarizer 4a such that only the component that matches the direction of polarization permitted to pass through the polarizer 4a is selected. Given that the direction of polarization of the laser beam is angled by an angle θ against the direction of polarization permitted to pass through the polarizer 4a, the intensity of laser beam past the polarizer 4a is cos²θ times as that of the laser beam having its direction of polarization matching the direction of polarization permitted to pass through the polarizer 4a. Subsequently, the laser beam past the polarizer 4a has its direction of polarization rotated by 45° by the rotator 4b as in the related art and then passes through the analyzer 4c, which permits the direction of polarization matching that of the rotated laser beam to pass therethrough. Given that the optical output of the optical fiber 7 is 4mW, occurring when an optimum bias current is supplied to the laser diode 1 and the optical isolator 4 is placed for the direction of polarization permitted to pass through the polarizer 4a to match that of the incident laser beam, an optical output of 2mW may be provided by the end surface of optical fiber 7 facing the isolator 4 being located at the maximum coupling point 6, according to the first embodiment. This is achieved by placing the optical isolator 4 so that the direction of polarization permitted to pass through the polarizer 4a is angled by 45° against the direction of polarization of the incident laser beam. The returning laser beam entering the analyzer 4c in a backward direction is prevented from passing through the optical isolator 4, as in the related art.

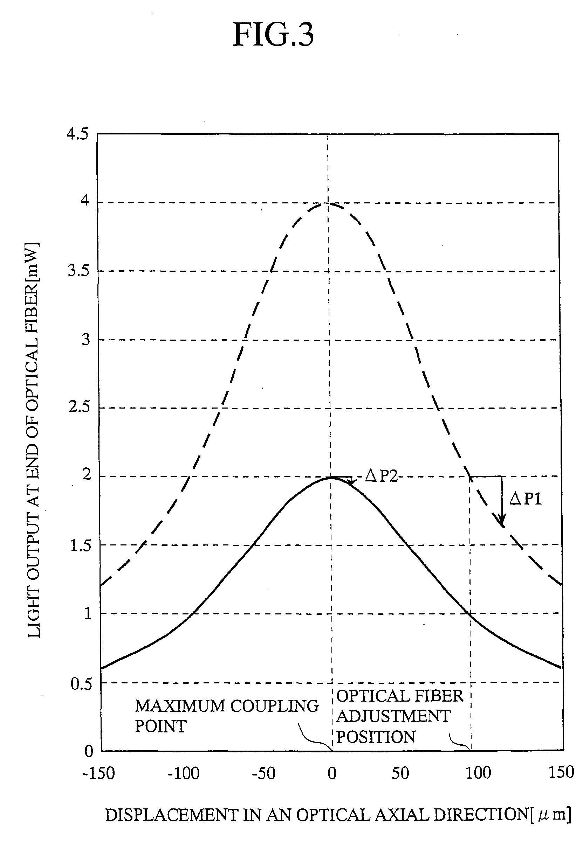

Fig. 3 is a graph showing a relationship between the position of the optical fiber 7 and the optical output provided by the optical fiber 7, occurring when an optimum bias current is supplied to the optical fiber 7 and the optical isolator 4 is placed so that the direction of polarization permitted to go through the polarizer is angled against the direction of polarization of the incident laser beam. The intensity of laser beam is assumed to exhibit a gaussian distribution. The spot size of the laser diode 1 is 1µm, the spot size of the optical fiber 7 is 5µm, the power of the optical system between the laser diode 1 and the optical fiber 7 is 4. The optical isolator 4 is placed so that the direction of polarization permitted to pass through the polarizer 4a is angled by 45° against the direction of polarization of the incident laser beam. The optimum bias current is supplied to the laser diode 1 such that the maximum optical output of the optical fiber 7 would be 4mW when the optical isolator 4 is placed so that the direction of polarization permitted to pass through the polarizer 4a matches that of the incident laser beam. Referring to Fig. 3, the optical fiber 7 should be secured at the maximum coupling point 6 when a desired optical output is 2mW. Fig. 3 shows that, by placing the optical fiber 7 at the maximum coupling point 6, the optical output provided by the optical fiber 7 varies only to a limited extent when the optical fiber 7 is slightly displaced from the original position due to deformation caused by stress or variation in ambient temperature.

The broken line of Fig. 3 shows that, in a related-art arrangement where the maximum optical output of 4mW is provided by the optical fiber 7 by supplying an optimum bias current to the laser diode 1 and placing the optical isolator for the direction of polarization permitted to pass through the polarizer to match that of the incident laser beam, production of a desired optical output level of 2mW by the optical fiber 7 requires that the optical fiber 7 be secured to a position removed from the maximum coupling point 6. The graph reveals that, if an accidental relative displacement of 20µm occurs between the maximum coupling point 6 and the end surface of the optical fiber 7, the optical output from the optical fiber 7 drops approximately by 18.3%. In contrast, by placing the optical isolator 4 so that the direction of polarization permitted to pass through the polarizer 4a is angled by 45° against that of the incident laser beam, and by placing the optical fiber 7 at the maximum coupling point 6, the optical output from the optical fiber 7 drops only by 4.0% when the end surface of the optical fiber 7 is displaced from the maximum coupling point 6 by 20µm. Thus, a stable optical output is provided.

As described, the power of laser beam passing through the polarizer of the optical isolator is attenuated by securing the optical isolator so that the direction of polarization permitted to pass through the polarizer is angled against that of the laser beam incident on the optical isolator. The optical output from the optical fiber is ensured to have a desired level when the optical fiber is located at the maximum coupling point. The result is a laser diode module which produces an optical output that varies only to a limited extent due to deformation caused by stress and variation in ambient temperature, and which is easy to fabricate in order to provide a desired optical output.

### Second embodiment

The arrangement of the first embodiment may be varied by replacing the entirety of the optical isolator 4 by the polarizer 4a alone. The same advantage is achieved as long as the polarizer 4a is placed so that the direction of polarization permitted to pass through the polarizer 4a is angled against that of the laser beam past the lens 2 to ensure a desired level of optical output from the optical fiber 7 secured to the maximum coupling point 6.

### Third embodiment

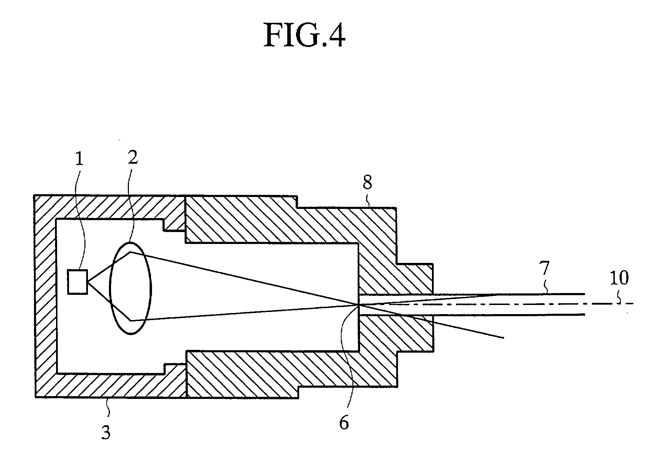

Fig. 4 shows a construction of a laser diode module according to a third embodiment of the present invention. Referring to Fig. 4, reference numerals 1-8 indicate respective components that are identical to the components of the related-art laser diode module so that the description thereof is omitted. The laser diode 1 and the lens 2 are arranged so that the laser beam past the lens 2 enters the optical fiber 7 at an angle other than 0° with respect to an axis 10 of the optical fiber 7. The angle formed between the end surface of the optical fiber 7, facing the lens 2 and leaned against the axis 10 of the optical fiber 7, and an optical axis of the laser beam entering the optical fiber 7 is controlled by rotating the optical fiber 7 around the axis 10 while maintaining it at the maximum coupling point 6. The optical fiber 7 is fixed at a rotation to provide a desired optical output level.

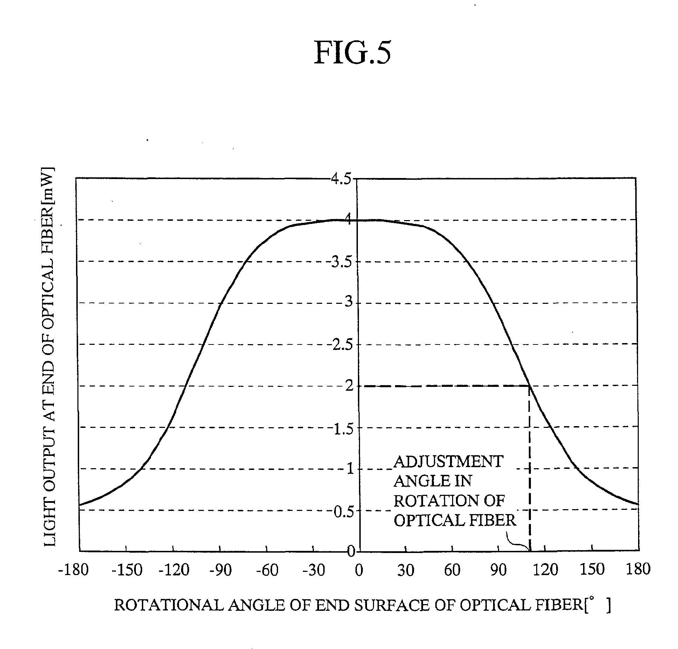

Fig. 5 shows a relationship between the angle of rotation of the optical fiber 7 of Fig. 4 and the level of optical output from the optical fiber 7 located at the maximum coupling point 6. The intensity of laser beam is assumed to exhibit a gaussian distribution. The spot size of the laser diode 1 is 1µm, the spot size of the optical fiber 7 is 5µm, the power of the optical system between the laser diode 1 and the optical fiber 7 is 4, and the maximum optical output of the optical fiber 7 is 4mW when the optimum bias current is supplied to the laser diode 1. In the graph of Fig. 5, the angle formed by the laser beam entering the optical fiber 7 against the axis 10 of the optical fiber 7 is -3.8°, and the angle formed by a normal of the end surface of the optical fiber 7 facing the lens 2 against the axis 10 of the optical fiber 7 is 8.0°. Referring to Fig. 5, when the desired optical output is 2mW, the optical fiber should be secured to a position rotated by approximately 114.4° around the axis 10. By controlling the angle of rotation of the optical fiber 7 before securing the optical fiber 7, the same advantage as provided by the first embodiment are achieved as well as the second embodiment.

The present invention is not limited to the above-described embodiments, and variations and modifications may be made without departing from the scope of the present invention.

## Claims

1. A laser diode module **characterized by** comprising:
a laser diode (1);
a lens (2) provided on an optical path of a laser beam emitted by said laser diode;
a polarizer (4a) provided on an optical path of the laser beam transmitted by said lens; and
an optical fiber (7) provided at a location (6) to which the laser beam transmitted by said polarizer is optimally coupled, further **characterized in that**
said polarizer is angled so that a direction of polarization permitted to pass through said polarizer is angled against a direction of polarization of the laser beam transmitted by said lens.

2. The laser diode module according to claim 1, **characterized in that** said optical fiber is provided in the vicinity of the location to which the laser beam transmitted by said polarizer is optimally coupled.

3. The laser diode module according to claim 1 or claim 2, **characterized in that** said polarizer is placed so that the direction of polarization permitted to pass through said polarizer is angled against a direction of polarization of the laser beam from said laser diode at an angle that ensures a desired level of optical output from said optical fiber.

4. A laser diode module **characterized by** comprising:
a laser diode (1);
a lens (2) provided on an optical path of a laser beam emitted by said laser diode;
an optical isolator (4) provided on an optical path of the laser beam transmitted by said lens and including a polarizer (4a), a rotator (4b) and an analyzer (4c); and
an optical fiber (7) provided at a location (6) to which the laser beam transmitted by said optical isolator is optimally coupled, further **characterized in that**
said optical isolator is placed so that a direction of polarization permitted to pass through said optical isolator is angled against a direction of polarization of the laser beam from said laser diode.

5. The laser diode module according to claim 4, **characterized in that** said optical fiber is provided in the vicinity of the location to which the laser beam transmitted by said optical isolator is optimally coupled.

6. The laser diode module according to claim 4 or claim 5, **characterized in that** said optical isolator is placed so that the direction of polarization permitted to pass through said optical isolator is angled against a direction of polarization of the laser beam from said laser diode at an angle that ensures a desired level of optical output from said optical fiber.

7. A laser diode module **characterized by** comprising:
a laser diode (1);
a lens (2) provided on an optical path of a laser beam emitted by said laser diode;
an optical fiber (7) provided with an end surface facing said lens and leaned against an axis (10) of said optical fiber, and placed so that the laser beam transmitted by said lens is coupled into said optical fiber at an angle against the axis of said optical fiber,
the end surface of said optical fiber being provided at a location at which the laser beam transmitted by said lens is coupled into said optical fiber with a maximum efficiency, and
said optical fiber being leaned against the axis at an angle that ensures a desired level of optical output.
